# EUROPEAN PATENT APPLICATION

(11) **EP 2 330 479 A1**
(43) Date of publication of application: **08.06.2011**
(21) Application number: 10187139.0
(22) Date of filing: 11.10.2010
(51) Int. Cl.: G06F 1/16

(54) **Memory shape element for flexible OLED display screen**

(30) Priority: 14.10.2009 US 578854
(71) Applicant: Sony Corporation, Tokyo 108-0075 (JP); Sony Electronics Inc., Park Ridge, NJ 07656 (US)
(72) Inventor: Ebbeling, Daniel, San Diego, CA 92127-1898 (US); McCray, Dennis Jacob, San Diego, CA 92127-1898 (US); Double, Matthew, San Diego, CA 92127-1898 (US)
(74) Representative: McGowan, Cathrine

(57) **Abstract**

An OLED display has one or more shape memory wires disposed along respective edges of the display and energizable under control of a processor to flatten the display from a rolled or folded configuration.

## Description

### FIELD OF THE INVENTION

The present invention relates generally to memory shape elements for flexible organic light emitting diode (OLED) display screens.

### BACKGROUND OF THE INVENTION

Flexible organic light emitting diode (OLED) display screens currently on the market have gained popularity because of their unique ability to bend, fold and flex without breaking, yet still maintain their ability to property display an image after being bent, folded or flexed. Moreover, these display screens can be folded or rolled up for storage even though it is preferable that the screen be flat when in use.

However, such a screen may eventual develop material bias and it may be inconvenient for a user to hold the screen straight or flat when trying to view something. Including rigid edges with the flexible OLED display screen to keep the screen flat would not allow for the desired flexibility intended by flexible OLEDs.

Another problem arises when the flexible OLED display screen needs to be stored in a collapsed rather than flat manner by a user for easy storage. There is currently no solution for keeping flexible OLED display screens in a collapsed, compact form even though they may be collapsed into such a form.

### SUMMARY OF THE INVENTION

Aspects of the invention are defined in the appended claims.

Accordingly, in an embodiment, a computing device includes a housing holding a processor accessing a tangible computer readable storage medium, and an input device communicates with the processor. A flexible organic light emitting diode (OLED) display is coupled to the housing for displaying output in response to signals from the processor. The display is movable between a collapsed configuration and an extended configuration in which the display is substantially flat and parallelepiped-shaped. At least one shape memory element is coupled to the display and is energizable under control of the processor to establish a configuration of the display.

In example embodiments the input device may be a keyboard or keypad arranged on the housing. The shape memory element may straighten when energized in which case the configuration it establishes when energized is the extended configuration, with the shape memory element bending when deenergized.

When in the collapsed configuration, the display may be rolled up on itself. To this end the display may be materially biased to the collapsed configuration.

Alternatively, the shape memory element may be straight when deenergized and when energized bends, in which case the configuration it establishes when energized is the collapsed configuration. In this embodiment the display is materially biased to the extended configuration.

In example implementations the display may be coupled to the housing along a first edge of the display, and the display defines second and third edges perpendicular to the first edge in the extended configuration. The second and third edges terminate in a fourth edge that is parallel to the first edge in the extended configuration. The shape memory element may be disposed along the second edge. Or, the shape memory element may be a first shape memory element and the device can include a second shape memory element and no other shape memory elements, with the second shape memory element being disposed along the fourth edge. Yet again, the shape memory element may be a first shape memory element and the device can include a second shape memory element and a third shape memory element, with the second shape memory element being disposed along the fourth edge and the third shape memory element being disposed along the third edge.

Another embodiment comprises a computing device comprising:
housing holding a processor accessing a tangible computer readable storage medium;
input device communicating with the processor;
flexible organic light emitting diode (OLED) display coupled to the housing and displaying output in response to signals from the processor, the display being movable between a collapsed configuration and an extended configuration in which the display is substantially flat and parallelepiped-shaped; and at least one shape memory element coupled to the display and energizable under control of the processor to establish a configuration of the display.

In another embodiment, an information handling system includes a processor, a flexible display presenting images demanded by the processor, and shape memory means controlled by the processor for holding the display flat.

In another embodiment, a method includes, at boot time of a computer, actuating a shape memory element with energy and permitting the shape memory element to flatten a flexible display. The method also includes maintaining the shape memory element in a state of actuation during computer operation. Upon a predetermined energization condition, the shape memory element is controlled to permit the display to assume a collapsed configuration. If desired, the energization condition may be receipt of a power save signal generated by the computer after a predetermined period of inactivity.

### BRIEF DESCRIPTION OF THE DRAWINGS

Embodiments of the invention will now be described with reference to the accompanying drawings, throughout which like parts are referred to by like references, and in which:
Figure 1 is a schematic view of an extended configuration of a flexible OLED display screen with at least one memory shape element;
Figure 2 is a schematic view of a collapsed configuration of a flexible OLED display screen with at least one memory shape element;
Figure 3 is a perspective view of an example embodiment of the flexible OLED display screen having only one memory shape element;
Figure 4 is a perspective view of an example embodiment of the flexible OLED display screen having only two memory shape elements; and
Figure 5 is a perspective view of an example embodiment of the flexible OLEO display screen having three or more memory shape elements.

### DETAILED DESCRIPTION OF THE PREFERRED EMBODIMENT

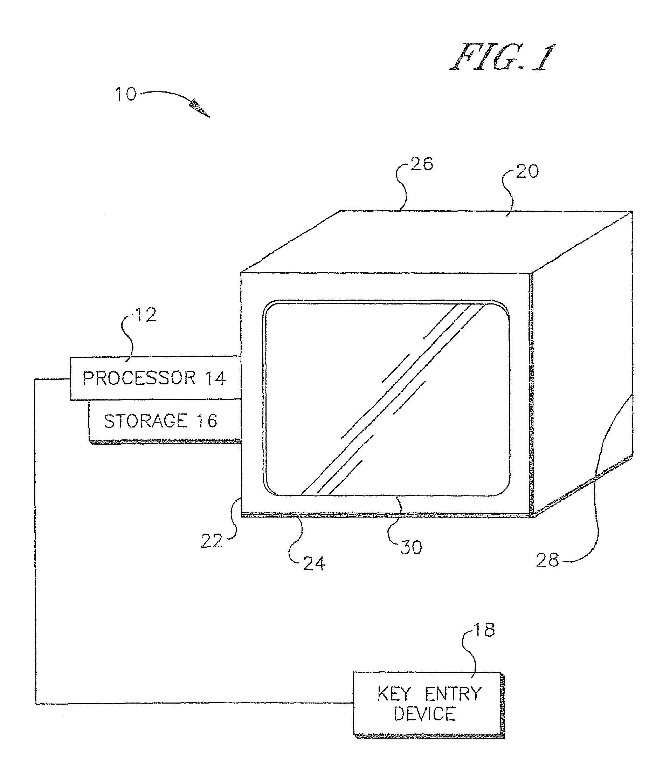

Beginning in reference to Figure 1, a flexible organic light emitting diode (OLED) display is shown. The flexible OLED display 10 is coupled to a housing 12. The housing 12 includes a processor 14 accessing a tangible computer storage medium 16. Further, the processor 14 may communicate with a data entry device 18 such as a keyboard, key pad arranged on the housing, touch sensitive slate with handwriting recognition module, remote control device, voice recognition module, or other input device.

The display 10 is capable of displaying output in response to signals from the processor 14. Thus, the key entry device 18 provides a method to allow a user to determine what is being displayed on the display 10 through its communication with the processor 14.

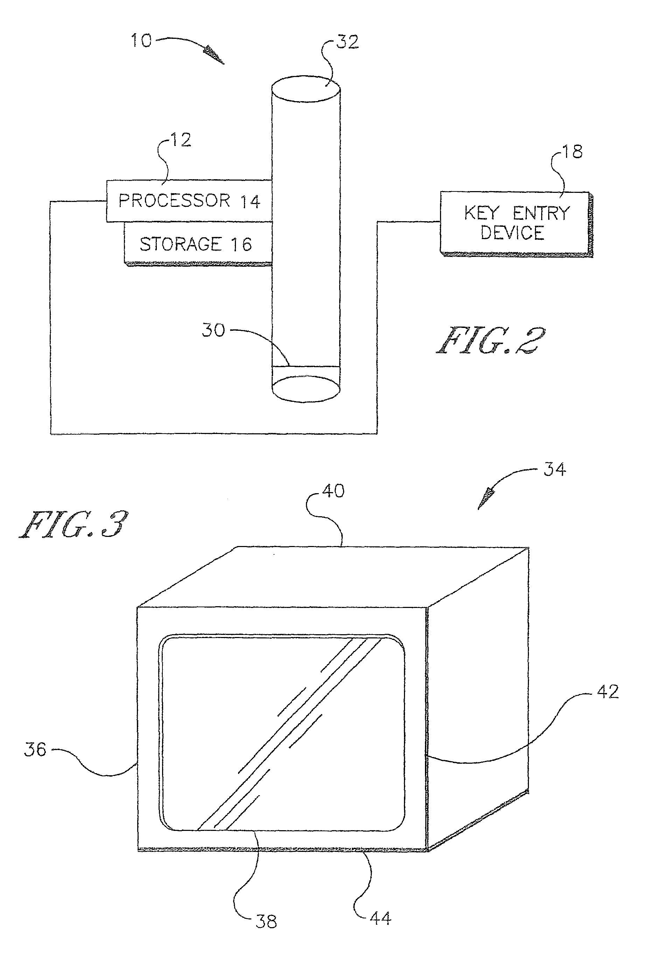

The display 10 is movable between an extended configuration 20 and a collapsed configuration which will be described in Figure 2. It is to be understood that the extended configuration 20 shown in Figure 1 is substantially flat and parallelepiped-shaped in non-limiting embodiments.

Further still, the display 10 is coupled to the housing 12 along a first edge 22 of the display 10. The display also has a second edge 24 and a third edge 26 which are perpendicular to the first edge. The second edge 24 and third edge 26 may terminate in a fourth edge 28 that is parallel to the first edge 22 in non-limiting embodiments of the extended configuration 22.

Still referencing Figure 1, the display 10 has at least one shape element 30 coupled to the display 10 which may be disposed along at least one edge of the display 10 in non-limiting embodiments, preferably along an edge perpendicular to the first edge 22. The element 30 is energizable under control of the processor 14 to establish a configuration of the display 10.

The element 30 may be automatically energized by the processor 14 as part of the booting process at power on to flatten the display. The element 30 may be automatically deenergized by the processor upon receipt of a power-down signal but prior to totally deenergizing the computer to allow the display to fold or roll up or otherwise collapse. Or, the element 30 may be automatically deenergized in response to a power save signal that might be generated by the computer after a predetermined period of inactivity.

It is to be understood that the element 30 need not be disposed along any edge of the display 10 per se, and may be coupled to the display 10 in any manner which allows the display 10 to have the capability to alternate between extended and collapsed configurations. This may also include manufacturing the display 10 with a piezo-electric material that straightens when energized so that no memory shape wires are required.

Now in reference to Figure 2, one example of a collapsed configuration of the flexible OLED display 10 referenced in Figure 1 is shown. In the non-limiting example embodiment of the display 10 shown in Figure 2, the collapsed configuration 32 may be a rolled configuration. The collapsed configuration 32 of the display 10 remains coupled to a housing 12, the housing 12 having a processor 14, tangible storage medium 16, and key entry device 18, all which function according to their respective descriptions provided in Figure 1.

Furthermore, the display 10 shown in the collapsed configuration 32 still has a first edge 22, a second edge 24, a third edge 26, a fourth edge 28 even through not shown in Figure 2. The display 10 also has at least one shape element 30 coupled to the display 10 and energizable under control of the processor 14.

Thus, it may now be appreciated that, in non-limiting embodiments, the shape element 30 straightens when energized to hold the display 10 in the extended configuration 20 described in Figure 1. The shape element 30 then bends when deenergized into the collapsed configuration 32 shown in Figure 2. Furthermore, the display 10 shown in Figure 2 can be materially biased to the collapsed configuration 32 when deenergized in non-limiting embodiments.

Alternatively, it is to be understood that in non-limiting embodiments, the shape memory element 30 may be straight when deenergized and bent when energized. In such an alternative non-limiting embodiment where energizing the at least one element 30 results in the collapsed configuration 32, the display 10 is materially biased to the extended configuration. However, it is to be understood that in still other non-limiting embodiments, the display 10 may be materially biased toward another configuration not described herein (e.g. a folded collapsed configuration instead of a rolled collapsed configuration).

Now referencing Figure 3, a flexible OLED display embodying current principles is shown. In non-limiting embodiments, the flexible OLED display 34 may be flat and parallelepiped-shaped, may be coupled to a housing not shown in Figure 3, and may be capable of displaying output in response to signals from a processor which is also not shown. Furthermore, the display 34 is substantially similar in function and configuration to the display 10 in Figures 1 and 2 (i.e. has a first edge attached to a housing, and second, third and fourth edges subject to the limitations described in reference to Figure 1 ),

The display 34 is also understood to be movable between a collapsed configuration and an extended configuration, substantially similar to the movement capability of the display 10 described in Figures 1 and 2. The display 34 may be materially biased toward an extended, collapsed, or alternative configuration in non-limiting embodiments. The display 34 also has a first edge 36 substantially similar in function and configuration to the first edge 22 shown in Figure 2. The first edge 36 is understood to be coupled to a housing not shown but substantially similar in function and configuration to the housing 12 shown in Figure 1. The display also has a second edge 38, third edge 40, and fourth edge 42, all of which are substantially similar in configuration to the second edge 24, third edge 26, and fourth edge 28 described in Figure 1.

Still referencing Figure 3, it may be appreciated that in the current non-limiting embodiment, the display 34 may have only one shape memory element 44 disposed along the second edge 38 with no shape memory elements along the third edge 40 or fourth edge 42.

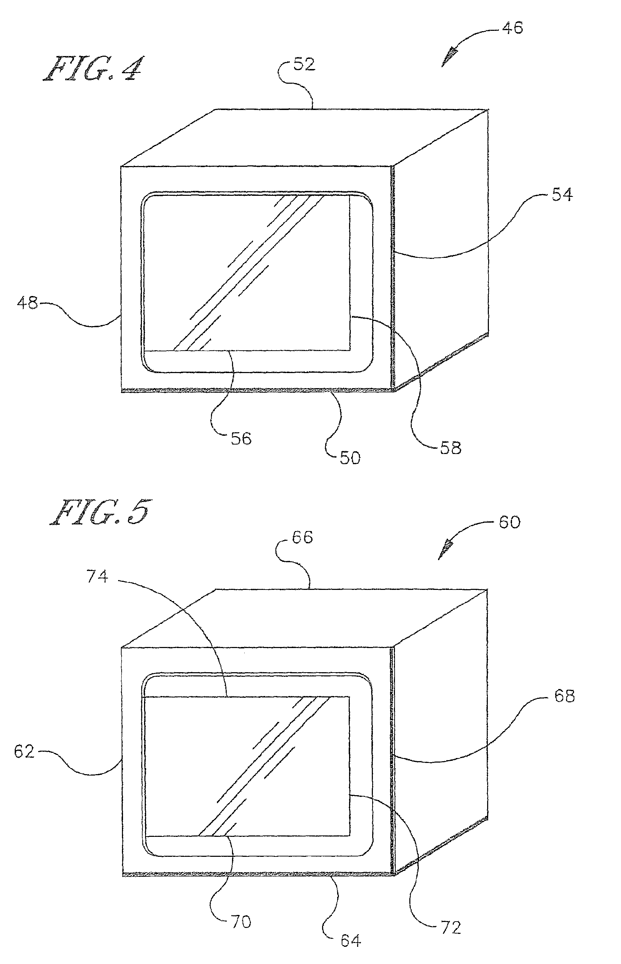

Continuing in reference to Figure 4, a display 46 substantially similar in function and configuration to the display 34 referenced in Figure 3 is shown. In this non-limiting embodiment, the display 46 has a first edge 48, a second edge 50, a third edge 52 and a fourth edge 54, all substantially similar in configuration to the edges 22, 24, 26, and 28 described in Figures 1 and 2. The display 46 has a first shape memory element 56 disposed along the second edge 50 and a second shape memory element 58 along the fourth edge 54. It may be appreciated that no other shape memory elements are present in Figure 4 besides the elements 56 and 58.

Now referencing Figure 5, a display 60 substantially similar in function and configuration to the display 34 referenced in Figure 3 is shown. In this non-limiting embodiment, the display 60 has a first edge 62, a second edge 64, a third edge 66, and a fourth edge 68, all substantially similar in configuration to the edges 22, 24, 26, and 28 described in Figures 1 and 2. The display 60 has a first shape memory element 70 disposed along the second edge 70 and a second shape memory element 72 disposed along the fourth edge 68. Further, the display 60 has a third shape memory element 74 disposed along the third edge 66. It may be appreciated that no other shape memory elements are present in Figure 4 besides the elements 70, 72, and 74.

While describing the present invention in reference to a flexible organic light emitting diode display, it is understood that the memory shape element principles described in Figures 1-5 may be applied to non-OLED displays as well.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

While the particular MEMORY SHAPE ELEMENT FOR FLEXIBLE OLED DISPLAY SCREEN is herein shown and described in detail, it is to be understood that the subject matter which is encompassed by the present invention is limited only by the claims.

Various respective aspects and features of the invention are defined in the appended claims. Combinations of features from the dependent claims may be combined with features of the independent claims as appropriate and not merely as explicitly set out in the claims.

## Claims

1. A computing device, comprising:
a processor;
a flexible display presenting images demanded by the processor; and
shape memory means controlled by the processor for holding the display flat.

2. The device of Claim 1, wherein the display is an OLED display and the shape memory means is at least one shape memory element.

3. The device of Claim 1, further comprising:
a housing holding the processor, the processor accessing a tangible computer readable storage medium; and
an input device communicating with the processor;
wherein the flexible display comprises a flexible organic light emitting diode (OLED) display coupled to the housing and displaying output in response to signals from the processor, the display being movable between a collapsed configuration and an extended configuration in which the display is substantially flat and parallelepiped-shaped; and
wherein the shape memory means comprises at least one shape memory element coupled to the display and energizable under control of the processor to establish a configuration of the display.

4. The device of Claim 3, wherein the input device is a keyboard or keypad arranged on the housing.

5. The device of Claim 2, wherein the shape memory element straightens when energized and the configuration it establishes when energized is a flat configuration, the shape memory element bending when deenergized.

6. The device of Claim 3, wherein the shape memory element straightens when energized and the configuration it establishes when energized is the extended configuration, the shape memory element bending when deenergized.

7. The device of Claim 2, wherein the displays rolls up when the shape memory element is deenergized.

8. The device of Claim 3, wherein when in the collapsed configuration the display is rolled.

9. The device of Claim 1 or Claim 3, wherein the display is materially biased to a collapsed configuration.

10. The device of Claim 2 or Claim 3, wherein the shape memory element is straight when deenergized and when energized bends, and the configuration it establishes when energized is a collapsed configuration, the display being materially biased to a flat or extended configuration.

11. The device of Claim 2 or Claim 3, wherein the display is coupled to a housing along a first edge of the display, the display defining second and third edges perpendicular to the first edge in the extended configuration, the second and third edges terminating in a fourth edge that is parallel to the first edge in the extended configuration, the shape memory element being disposed along the second edge.

12. The device of Claim 10, wherein the shape memory element is a first shape memory element and the device comprises a second shape memory element and no other shape memory elements, the second shape memory element being disposed along the fourth edge.

13. The device of Claim 10 wherein the shape memory element is a first shape memory element and the device comprises a second shape memory element and a third shape memory element, the second shape memory element being disposed along the fourth edge and the third shape memory element being disposed along the third edge.

14. Method comprising:
at boot time of a computer, actuating a shape memory element with energy;
permitting the shape memory element to flatten a flexible display;
maintaining the shape memory element in a state of actuation during computer operation; and
upon a predetermined energization condition, controlling the shape memory element to permit the display to assume a collapsed configuration.

15. The method of claim 14, wherein the energization condition is receipt of a power save signal generated by the computer after a predetermined period of inactivity.
